# EUROPÄISCHE PATENTSCHRIFT

(11) **EP 1 168 034 B1**
(45) Veröffentlichungstag und Bekanntmachung des Hinweises auf die Patenterteilung: **05.11.2008**
(21) Anmeldenummer: 01114954.9
(22) Anmeldetag: 20.06.2001
(51) Int. Cl.: G02B 27/09, G01B 11/00

(54) **Beleuchtungseinrichtung und Koordinaten-Messgerät mit einer Beleuchtungseinrichtung**
Illumination device and illuminated coordinate measuring device
Appareil d'illumination et appareil de mesure de coordonnées illuminé

(30) Priorität: 29.06.2000 DE 10031719
(43) Veröffentlichungstag der Anmeldung: 02.01.2002
(73) Patentinhaber: Leica Microsystems CMS GmbH, 35578 Wetzlar (DE)
(72) Erfinder: Cemic, Franz, Dr., 35789 Weilmünster (DE); Danner, Lambert, 35584 Wetzlar-Naunheim (DE); Hoppen, Gerhard, 35578 Wetzlar (DE)
(74) Vertreter: Reichert, Werner Franz

(56) Entgegenhaltungen:
- EP-A- 0 905 439
- WO-A-97/03346
- WO-A-98/07001
- WO-A-99/53269
- WO-A-99/63384
- DE-A- 1 913 711
- DE-A- 3 624 687
- US-A- 4 505 555
- US-A- 4 721 359
- US-A- 4 964 692
- US-A- 5 907 395
- PATENT ABSTRACTS OF JAPAN vol. 016, no. 521 (E-1285), 27. Oktober 1992 (1992-10-27) -& JP 04 196280 A (MATSUSHITA ELECTRIC IND CO LTD), 16. Juli 1992 (1992-07-16)

## Beschreibung

Die Erfindung betrifft ein Koordinaten-Messgerät mit einer Beleuchtungseinrichtung mit den Merkmalen des Oberbegriffs des unabhängigen Anspruchs 1. Die Unteransprüche geben vorteilhafte Ausgestaltungen an.

Bei der Produktion von Halbleiter-Chips werden mit immer größerer Packungsdichte die Strukturbreiten der einzelnen Strukturen immer kleiner. Entsprechend den immer kleineren Strukturen, steigen die Anforderungen an die Spezifikationen von Koordinaten-Messgeräten, die als Mess- und Inspektionssysteme zur Messung der Kanten der Strukturen und der Position der Strukturen sowie zur Messung der Strukturbreiten eingesetzt werden. Bei diesen Koordinaten-Messgeräten werden immer noch optische Antastverfahren favorisiert, obwohl die Strukturbreiten schon kleiner als die zum Messen bzw. zur Inspektion verwendete Lichtwellenlänge sind. Der Grund liegt darin, dass Mess-Systeme mit optischen Antastverfahren wesentlich leichter zu benutzen sind als Systeme mit anderer Antastung, beispielsweise mit Elektronenstrahlen.

Aufgrund der immer kleineren zu messenden Strukturen steigen aber die Anforderungen an die Leistungsfähigkeit der Optik, insbesondere das Auflösungsvermögen. Um beispielsweise Strukturbreiten, Kantenprofile o. Ä. optisch reproduzierbar vermessen zu können, müssen die Messfelder möglichst homogen ausgeleuchtet werden.

Es sind Beleuchtungseinrichtungen bekannt, die zur Erzeugung eines homogenen Leuchtfeldes mit einem Lichtwellenleiter arbeiten. Eine solche Beleuchtungseinrichtung wird beispielsweise in dem Koordinaten-Messgerät Leica® LMS IPRO der Fa. Leica Microsystems GmbH verwendet.

In dieser Beleuchtungseinrichtung wird das Licht einer Lichtquelle über eine Einkoppeloptik mit kleiner Numerischer Apertur (z.B. von NA = 0.18) abgenommen und in einen Multimode-Lichtwellenleiter eingekoppelt. Als Lichtquelle wird dabei ein 100W-Hg-Xe-Entladungslampe verwendet. Der Multimode-Lichtwellenleiter besitzt einen geringen Kerndurchmesser von 0.4 mm und eine nominelle Numerische Apertur NA = 0.21. Über eine Auskoppeloptik wird dann mit Hilfe einer Tubuslinse und eines PLAN-APO 50x-Objektivs die Probe in bekannter Weise köhlersch beleuchtet. Mit dieser Beleuchtungseinrichtung wird ein Bildfeld mit einem Durchmesser von 0.056 mm beleuchtet. Um in diesem Fall eine gleichmässige Ausleuchtung mit Inhomogenitäten im Bereich von wenigen Prozent zu erreichen, wird von der Multimode-Faser nur eine kleine Numerische Apertur NA = 0,12 abgenommen. Das entspricht einem Halbwinkel von ca. 7°. Dadurch wird nur der Bereich der Abstrahlcharakteristik der Faser zur Beleuchtung verwendet, in dem die Intensität des Lichts als Funktion des Abstrahlwinkels nur im Prozentbereich variiert.

Die bekannte Beleuchtungseinrichtung besitzt den Vorteil, dass die Lichtquelle, die zugleich eine starke Wärmequelle ist, weit außerhalb des eigentlichen Messortes bzw. weit entfernt von der zu vermessenden Probe angeordnet werden kann. Dadurch werden Temperatureinflüsse auf die Messgenauigkeit des Koordinaten-Messgerätes minimiert. Zugleich wird das Beleuchtungslicht über den flexiblen Lichtwellenleiter an jeden beliebigen Messort geleitet.

Der Nachteil der bekannten Beleuchtungseinrichtung ist, dass aufgrund der Abstrahlcharakteristik von Multimode-Fasern der Winkelbereich, in dem die Intensität des abgestrahlten Lichts nur in der Größenordnung von wenigen Prozent variiert, sehr schmal ist. Sollen jedoch größere Felder homogen ausgeleuchtet werden, muß der Faserdurchmesser entsprechend groß dimensioniert werden. Die Steifigkeit optischer Fasern steigt mit zunehmendem Durchmesser stark an. Für zukünftige Koordinaten-Messgeräte wird beispielsweise ein homogen ausgeleuchtetes Bildfeld der Größe 0.35 mm benötigt. Dazu müßte eine optische Faser mit einem Kerndurchmesser größer als 1 mm eingesetzt werden, um eine hinreichende Homogenität im Bildfeld zu erzielen. Fasern mit einem Kerndurchmesser größer als 1 mm sind jedoch aufgrund ihrer Steifigkeit in der Praxis nicht mehr einsetzbar.

Es ist daher die Aufgabe der Erfindung, ein Koordinaten-Messgerät mit einer Beleuchtungseinrichtung zur homogenen Ausleuchtung eines deutlich größeren Bildfeldes als bisher möglich anzugeben, wobei gleichzeitig nur ein geringer Lichtverlust entstehen soll. Dabei sollen die Helligkeitsunterschiede im ausgeleuchteten Bildfeld sehr gering sein.

Diese Aufgabe wird gelöst durch ein Koordinaten-Messgerät mit einem horizontal xy-verschiebbaren Messtisch zur Aufnahme eines Substrates mit einer zu vermessenden Struktur, einem Beleuchtungssystem mit einer Lichtquelle einem Lichtwellenleiter, einer Einkoppeloptik vor dem Lichtwellenleiter, einer Auskoppeloptik nach dem Lichtwellenleiter, und einer Beleuchtungsoptik zur Ausleuchtung eines Bildfelds, und einer Detektoreinrichtung mit der die Position der Struktur als Koordinaten auf dem Substrat bestimmt wird, bei welchem erfindungsgemäß
a) als Lichtwellenleiter ein optisches Faserbündel angeordnet ist,
b) und in welchem zwischen der Auskoppeloptik und der Beleuchtungsoptik eine Homogenisierungsoptik angeordnet ist, welche die ungleichmässige Intensitätsverteilung des aus dem optischen Faserbündel austretenden Lichts im Bildfeld homogenisiert.

Vorteilhafte Ausgestaltungen der Erfindung sind Gegenstand der Unteransprüche.

Die Beleuchtungseinrichtung verwendet wiederum einen Lichtwellenleiter. Das Licht einer Lichtquelle wird über eine vergrößernde Einkoppeloptik mit möglichst großer Numerischer Eintrittsapertur (z.B. von NA = 0.60) abgenommen und in den Lichtwellenleiter eingekoppelt. Darin liegt bereits ein Unterschied zu der bekannten Beleuchtungseinrichtung, bei der das Licht der Lichtquelle über eine Einkoppeloptik mit kleiner Apertur abgenommen und in den Lichtwellenleiter eingekoppelt wurde. Da in der erfindungsgemäßen Beleuchtungseinrichtung vom hellsten Lampenausschnitt ein möglichst großer Winkel abgenommen wird, wird ein deutlicher Intensitätsgewinn erzielt.

Um jedoch zu vermeiden, dass eine optische Faser, d.h. ein Lichtwellenleiter, mit großem Kerndurchmesser eingesetzt werden muß, wird statt dessen ein Faserbündel eingesetzt. Das von dem Faserbündel emittierte Licht, das üblicherweise eine unbefriedigende Intensitätsverteilung aufweist, wird erfindungsgemäß mit einer Homogenisierungsoptik in eine sogenannte "Flat-Top-Verteilung" (sogenannter Super-Gauss) transformiert.

Als Homogenisierungsoptiken können refraktive Linsenarrays, Holografische Optische Elemente (HOE), Diffraktive Optische Elemente (DOE), Wabenkondensoren oder Kombinationen aus Linsenarrays und Streuscheiben eingesetzt werden.

Als die optimale Lösung für die Homogenisierungsoptik hat sich jedoch eine Hintereinanderschaltung eines Mikrowabenkondensors und eines Linsengliedes herausgestellt. Der Mikrowabenkondensor besteht aus zwei miteinander verkitteten Quarzplatten, die jeweils an den Außenflächen ein dichtes Array von plankonvexen Mikrolinsen aufweisen, wobei die beiden Außenflächen wechselseitig in der Fokusebene der Mikrolinsen an der jeweils gegenüberliegenden Außenfläche stehen. Mit zunehmender Anzahl der durchstrahlten Mikrolinsen nähert sich die Homogenität an ein Optimum an. Diese optimale Homogenität der Helligkeit im Bildfeld wird durch eine weitere Erhöhung der Anzahl der Mikrolinsen nicht mehr nennenswert gesteigert werden.

Da die Intensitätsverteilung des aus dem Lichtleiter emittierten Lichts durch den erfindungsgemäßen Einsatz einer Homogenisierungsoptik in guter Näherung keinen Einfluß mehr auf das Intensitätsprofil im Bildfeld hat, kann statt einer Einzelfaser mit großem Kerndurchmesser auch ein Faserbündel bestehend aus vielen Einzelfasem eingesetzt werden. Dieser Lichtleitertyp weist auch bei großem Durchmesser eine geringe Steifigkeit auf. Bei Einzelfasern ist die Abstrahlcharakteristik stark vom Krümmungszustand der Faser abhängig, was einen größeren Justageaufwand erfordert. Faserbündel sind dagegen deutlich unempfindlicher gegenüber Krümmungen. Dabei ist die Lichtbilanz, also der Quotient aus der Gesamtintensität im Bildfeld zur Intensität des von der Faser emittierten Lichts, bei einer Homogenisierung mittels eines Linsenarrays vergleichsweise am günstigsten.

Mit der Beleuchtungseinrichtung wird ein homogen ausgeleuchtetes Bildfeld mit einem Mindestdurchmesser von 0.35 mm bei einer numerischen Apertur von 0.60 erzielt. Die Beleuchtungs-Inhomogenität beträgt weniger als ± 2% des Mittelwerts zwischen der Maximal-Intensität und der Minimal-Intensität.

In einem erfindungsgemäßen Koordinaten-Messgerät, mit dem Strukturen von Lithografie-Masken der Halbleiter-Industrie vermessen werden, ist das homogen ausgeleuchtete Bildfeld damit gleich groß. Dadurch ist beispielsweise ein Nachfokussieren auf Veränderungen der Lage der Strukturebenen, die aufgrund der fertigungsbedingten Masken-Dickentoleranzen auftreten, nicht notwendig. Auch hier beträgt die Beleuchtungs-Inhomogenität weniger als ± 2% des Mittelwerts zwischen der Maximal-Intensität und der Minimal-Intensität. Dies führt zu einer deutlichen Verbesserung der Messgenauigkeit, insbesondere bei großen Masken.

Die Erfindung wird anhand mehrerer Ausführungsbeispiele mit Hilfe der schematischen Zeichnung näher erläutert. Es zeigen:
- ***Fig. 1*:**: Optikschema einer Beleuchtungseinrichtung für eine Durchlicht-Beleuchtung;
- ***Fig. 2*:**: Detailvergrößerung "X" aus Fig. 1, Schnitt durch einen Wabenkondensor;
- ***Fig. 3*** :: Optikschema einer Beleuchtungseinrichtung für eine Auflicht-Beleuchtung;
- ***Fig. 4*:**: ein Koordinaten-Messgerät mit einer einer kombinierten Auflicht- und Durchlicht-Beleuchtung, welche eine Durchlicht-Beleuchtungseinrichtung umfasst;
- ***Fig. 5***:: schematischer Strahlengang vor und nach dem Kondensor der Durchlicht-Beleuchtungseinrichtung aus ***Fig. 4*** für unterschiedlich dicke Masken.

In den Figuren sind gleichartige Elemente mit denselben Bezugsziffern bezeichnet.

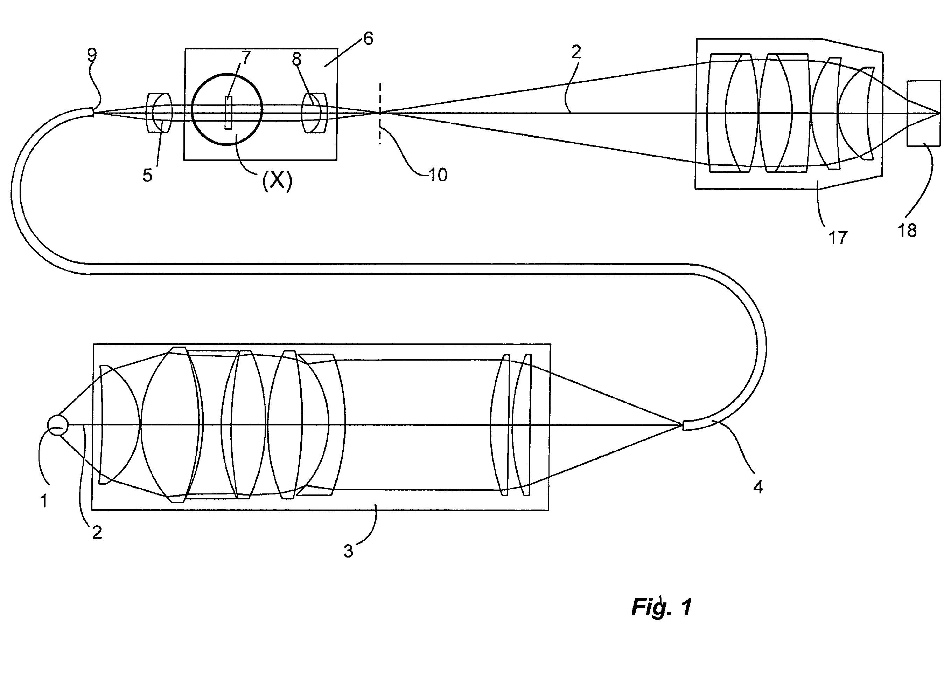

***Fig. 1*** zeigt das Optikschema einer Beleuchtungseinrichtung, hier speziell für eine Durchlichtbeleuchtung, wie sie beispielsweise in einem Koordinaten-Messgerät oder einem Stepper verwendet werden kann.

Von einer Lichtquelle 1 geht ein Durchlicht-Beleuchtungsstrahlengang mit einer optischen Achse 2 aus. Das Licht der Lichtquelle 1 wird über eine vergrößernde Einkoppeloptik 3 mit möglichst großer Numerischer EintrittsApertur (z.B. von NA = 0.60) abgenommen und in einen Lichtwellenleiter eingekoppelt. Als Lichtwellenleiter wird ein optisches Faserbündel 4 verwendet.

Eine Auskoppeloptik 5, die vorzugsweise als ein Achromat ausgebildet ist, kollimiert das von dem Faserbündel 4 emittierte Licht. Dabei bleibt die inhomogene Intensitätsverteilung des von dem Faserbündel 4 emittierten Lichts erhalten. Daher wird das kollimierte Licht am Ausgang der Auskoppeloptik 5 erfindungsgemäß auf eine Homogenisierungsoptik 6 gerichtet, welche die inhomogene Intensitätsverteilung in eine sogenannte "Flat-Top-Verteilung" (sogenannter Super-Gauss) transformiert.

Die Homogenisierungsoptik 6 besteht in diesem Ausführungsbeispiel aus einem Mikrowabenkondensor 7 und einem Linsenglied 8, welche die Austrittsöffnung 9 des Faserbündels 4 in einer Zwischenbildebene 10 zu einem homogenen Zwischenbild überlagern.

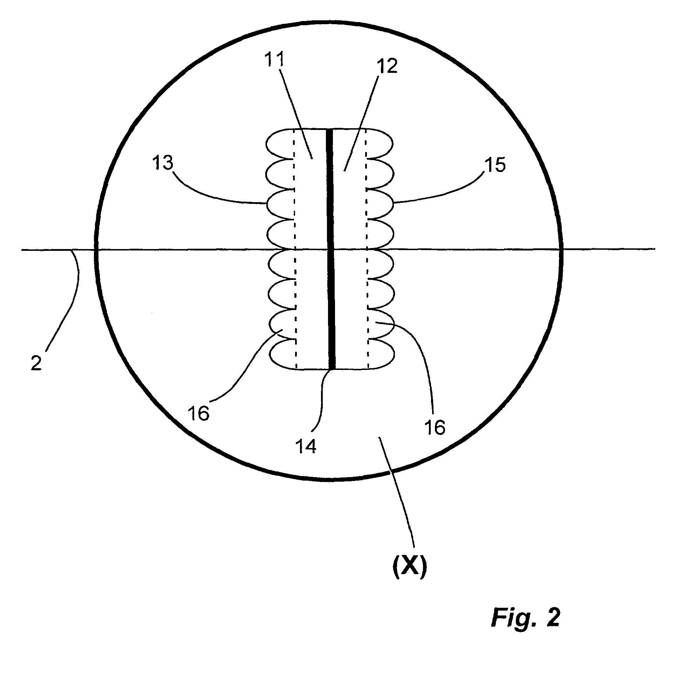

***Fig. 2*** zeigt eine Detailvergrößerung des in ***Fig. 1*** mit "X" bezeichneten Bereichs. Dargestellt ist ein Schnitt durch einen Mikrowabenkondensor 7. Die vordere Außenfläche 13 des Mikrowabenkondensors 7 (in der Figur links angeordnet) befindet sich in der Brennebene der Auskoppeloptik 5.

Der Mikrowabenkondensor 7 besteht aus einer ersten, planen Quarzplatte 11 und einer zweiten, planen Quarzplatte 12, die beide miteinander verkittet sind. Die Kittfläche 14 zwischen der ersten Quarzplatte 11 und der zweiten Quarzplatte 12 ist unverhältnismäßig dick dargestellt.

Die Außenfläche 13 der ersten Quarzplatte 11 stellt die Vorderseite des Mikrowabenkondensors 7 dar, auf welche das von der Auskoppeloptik 5 kommende Licht auftrifft. Die Außenfläche 15 der zweiten Quarzplatte 12 stellt die Rückseite des Mikrowabenkondensors 7 dar, durch welche das Licht wieder austritt.

In die Außenfläche 13 der ersten Quarzplatte 11 und in die Außenfläche 15 der zweiten Quarzplatte 12 sind in einer hexagonalen Anordnung plankonkave Mikrolinsen (Positiv-Linsen) 16 geätzt. Das Ätzen kann beispielsweise mit einem lithografischen Prozess erfolgen. Die beiden Außenflächen 13 und 15 stehen wechselseitig im jeweiligen Fokus der an der jeweils gegenüberliegenden Außenfläche 13, 15 angeordneten Mikrolinsen 16.

Auf der Rückfläche des Mikrowabenkondensors 7 erhält man dadurch Vielfachbilder der Austrittsöffnung 9 des Faserbündels 4. Die Zahl der Vielfachbilder entspricht der Zahl der ausgeleuchteten Mikrolinsen 16. Die Größe der Vielfachbilder bestimmt sich aus dem Brennweitenverhältnis des Achromaten 5 und der Brennweiten der Mikrolinsen 16.

Der weitere Strahlengang ist wieder in ***Fig. 1*** gezeigt. Das Linsenglied 8, das vorzugsweise als ein Achromat ausgebildet ist, bildet dann die Querschnitte der Mikrolinsen 16 auf der vorderen Außenfläche 13 des Mikrowabenkondensors 7 übereinander in eine Zwischenbildebene 10 ab. Diese Überlagerung sorgt, wenn die Zahl der Mikrolinsen 16 groß genug gewählt wurde, für ein sehr homogenes Zwischenbild.

Mit einem Kondensor 17, der als Beleuchtungsoptik angeordnet ist, wird das homogenisierte Zwischenbild dann verkleinert auf ein Durchlicht-Objekt 18 abgebildet. Gleichzeitig wird die Austrittsfläche des Mikrowabenkondensors 15 durch den Kondensor 17 ins Unendliche abgebildet. Man erhält auf diese Weise die gewünschte homogene Ausleuchtung des Objektfeldes auf dem Durchlicht-Objekt 18. Das Durchlicht-Objekt 18 kann beispielsweise das Messfeld eines Koordinaten-Messgeräts oder ein Präparat auf einem Mikroskoptisch sein.

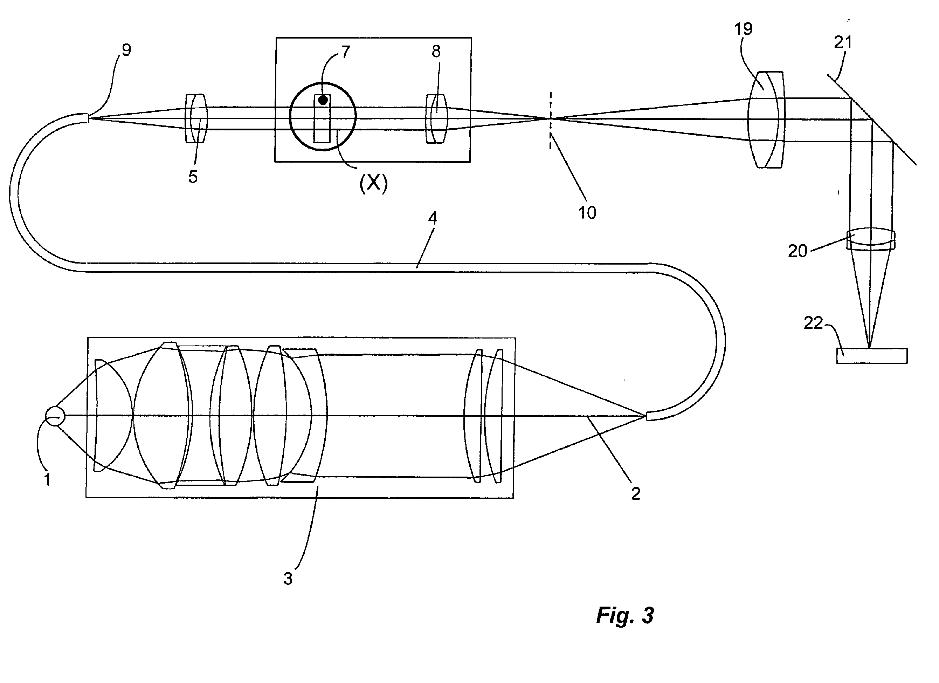

***Fig. 3*** zeigt das Optikschema einer Beleuchtungseinrichtung, hier speziell für eine Auflichtbeleuchtung, wie sie beispielsweise in einem Koordinaten-Messgerät oder einem Stepper verwendet werden kann.

Von einer Lichtquelle 1 geht ein Auflicht-Beleuchtungsstrahlengang mit einer optischen Achse 2 aus. Das Licht der Lichtquelle 1 wird über eine vergrößernde Einkoppeloptik 3 mit möglichst großer Numerischer EintrittsApertur (z.B. von NA = 0.60) abgenommen und in einen Lichtwellenleiter eingekoppelt. Als Lichtwellenleiter wird ein optisches Faserbündel 4 verwendet.

Zunächst wird das von dem Faserbündel 4 emittierte Licht mit einer Auskoppeloptik 5, die vorzugsweise als ein Achromat ausgebildet ist, kollimiert. Dabei bleibt die inhomogene Intensitätsverteilung des von dem Faserbündel 4 emittierten Lichts erhalten. Daher wird das kollimierte Licht am Ausgang der Auskoppeloptik 5 erfindungsgemäß auf einen Mikrowabenkondensor 7 gerichtet, der Teil einer Homogenisierungsoptik 6 ist, welche die inhomogene Intensitätsverteilung in eine sogenannte "Flat-Top-Verteilung" (sogenannter Super-Gauss) transformiert.

Auf der Rückfläche des Mikrowabenkondensors 7 erhält man dann, wie bereits beschrieben, Vielfachbilder der Lichtquelle, im vorliegenden Fall also der Austrittsöffnung 9 des Faserbündels 4. Die Zahl der Vielfachbilder entspricht der Zahl der ausgeleuchteten Mikrolinsen 16.

Ein Linsenglied 8, das vorzugsweise als ein Achromat ausgebildet ist, bildet dann die Querschnitte der Mikrolinsen 16 auf der vorderen Außenfläche 13 des Mikrowabenkondensors 7 übereinander in eine Zwischenbildebene 10 ab. Diese Überlagerung sorgt, wenn die Zahl der Mikrolinsen 16 groß genug gewählt wurde, für ein homogenes Zwischenbild.

Mit einer Linsengruppe 19 und einem als Beleuchtungsoptik angeordneten Objektiv 20 , zwischen denen ein Strahlteiler 21 angeordnet ist, wird das homogenisierte Zwischenbild dann verkleinert auf ein Auflicht-Objekt 22 und die als Pupille fungierende Rückseite des Mikrowabenkondensors 15 im Objektraum ins Unendliche abgebildet. Man erhält auf diese Weise die gewünschte homogene Ausleuchtung des Objektfeldes auf dem Auflicht-Objekt 22. Das Auflicht-Objekt 22 kann beispielsweise ein Messfeld eines Koordinaten-Messgeräts oder ein Präparat auf einem Mikroskoptisch sein.

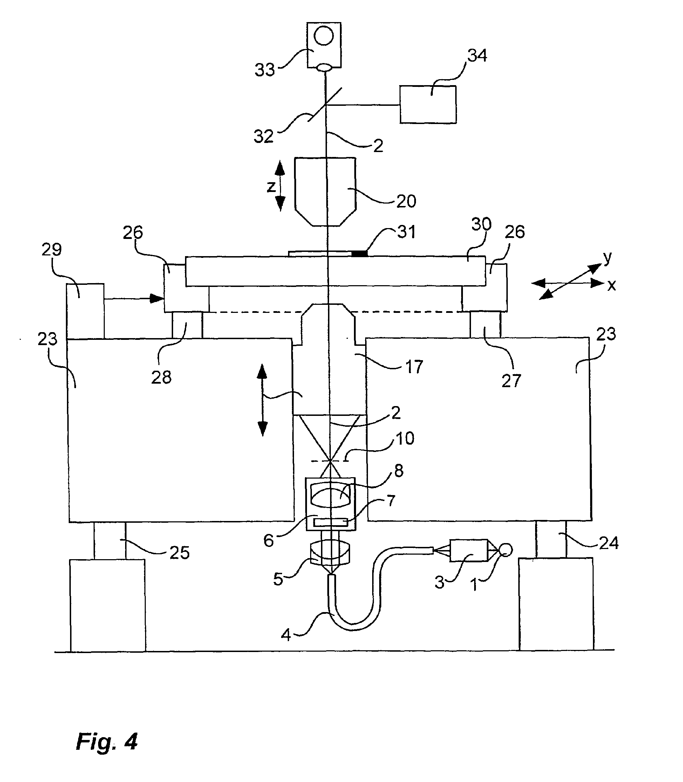

***Fig. 4*** zeigt ein Ausführungsbeispiel für ein Koordinaten-Messgerät mit einer einer kombinierten Auflicht- und Durchlicht-Beleuchtung, welche eine Durchlicht-Beleuchtungseinrichtung umfasst.

Das dargestellte Koordinaten-Messgerät weist einen Granitblock 23 auf, der auf Schwingungsdämpfern 24, 25 gelagert ist. Auf dem Granitblock 23 ist ein als Rahmen ausgebildeter Messtisch 26 auf Luftlagern 27, 28 in x- und y-Richtung (in der Zeichnung durch zwei Pfeile angedeutet) gleitend verschiebbar. Der Rahmen des Messtisches 26 besteht vorteilhafterweise aus einer Glaskeramik mit geringem thermischen Ausdehnungskoeffizienten. Die Antriebselemente zum Verfahren des Messtisches 26 sind nicht dargestellt. Die Position des Messtisches 26 wird mit einem Laser-Interferometer-System 29 in x- und y-Richtung gemessen.

In den Rahmen des Messtisches 26 ist eine Maske 30 eingelegt. Die Maske 30 besteht z.B. aus Quarzglas. Auf der Maskenoberfläche sind Strukturen 31 aufgebracht. Da der Messtisch 26 als Rahmen ausgebildet ist, kann die Maske 30 auch von unten her durchleuchtet werden.

Oberhalb der Maske 30 befindet sich als Abbildungssystem ein Objektiv 20 hoher optischer Güte, das zur Fokussierung längs seiner optischen Achse 2 in z-Richtung verstellbar ist. Über einen Teilerspiegel 32 wird zum einen das Licht einer Auflicht-Lichtquelle 33 in den optischen Strahlengang eingeleitet und zum anderen werden die Abbildungsstrahlen auf eine Detektor-Einrichtung 34 gelenkt. Die Detektor-Einrichtung 34 ist z.B. eine CCD-Kamera mit hochauflösendem Pixelarray. Die Auflicht-Lichtquelle 33 emittiert beispielsweise im nahen UV-Spektralbereich. Mittels der Detektor-Einrichtung 34 wird die Position einer Struktur 31 als Koordinaten auf der Maske 30 bestimmt.

In den Granitblock 23 ist als weitere Beleuchtungseinrichtung eine Durchlicht-Beleuchtungseinrichtung mit einem höhenverstellbaren Kondensor 17 und einer Lichtquelle 1 eingesetzt. Von der Lichtquelle 1 geht ein Durchlicht-Beleuchtungsstrahlengang mit einer optischen Achse 2 aus. Das Licht der Lichtquelle 1 wird über eine vergrößernde Einkoppeloptik 3 mit möglichst großer Numerischer Eintrittsapertur (z.B. von NA = 0.60) abgenommen. Auf diese Weise wird besonders viel Licht der Lichtquelle aufgenommen. Allerdings weist das Licht über diese große Apertur besonders große Intensitätsinhomogenitäten auf. Das aufgenommene Licht wird mit der Einkoppeloptik 3 in einen Lichtwellenleiter eingekoppelt. Als Lichtwellenleiter wird ein optisches Faserbündel 4 verwendet.

Eine Auskoppeloptik 5, die vorzugsweise als ein Achromat ausgebildet ist, kollimiert das von dem Faserbündel 4 emittierte Licht. Dabei bleibt die inhomogene Intensitätsverteilung des von dem Faserbündel 4 emittierten Lichts erhalten. Daher wird das kollimierte Licht am Ausgang der Auskoppeloptik 5 erfindungsgemäß auf eine Homogenisierungsoptik 6 gerichtet, welche die inhomogene Intensitätsverteilung in eine sogenannte "Flat-Top-Verteilung" (sogenannter Super-Gauss) transformiert.

Die Homogenisierungsoptik 6 besteht in diesem Ausführungsbeispiel aus einem Mikrowabenkondensor 7 und einem Linsenglied 8, welche die Austrittsöffnung 9 des Faserbündels 4 in einer Zwischenbildebene 10 zu einem homogenen Zwischenbild überlagern. Mit dieser Ausführungsform der Homogenisierungsoptik können auch starke Intensitätsunterschiede, die aufgrund der großen numerischen Apertur der Einkoppeloptik auftreten, sehr gut homogenisiert werden. Die verbleibende Beleuchtungs-Inhomogenität beträgt lediglich weniger als ± 2% des Mittelwerts zwischen der Maximal-intensität und der Minimal-Intensität. Dies führt zu einer deutlichen Verbesserung der Messgenauigkeit der Koordinaten der Strukturen 31, insbesondere bei großen Masken 30.

Die optische Achse des Kondensors 17 fluchtet mit der optischen Achse 2 des Objektivs 20. Die Höhenverstellung des Kondensors 17 dient der Anpassung der auf die Struktur 31 zu richtenden Beleuchtungsstrahlen an unterschiedliche optische Dicken von Masken 30. Der Kondensorkopf kann insbesondere in den offenen Teil des Messtischrahmens hineinreichen. Zum Schutz vor Beschädigungen bei Verschiebungen des Messtisches 26 über die gesamte Maskenfläche kann der Kondensor 26 aber auch unter die Oberfläche des Granitblocks 23 gezogen werden. Die Lichtquellen 1 und 33 sind voneinander unabhängig einschaltbar.

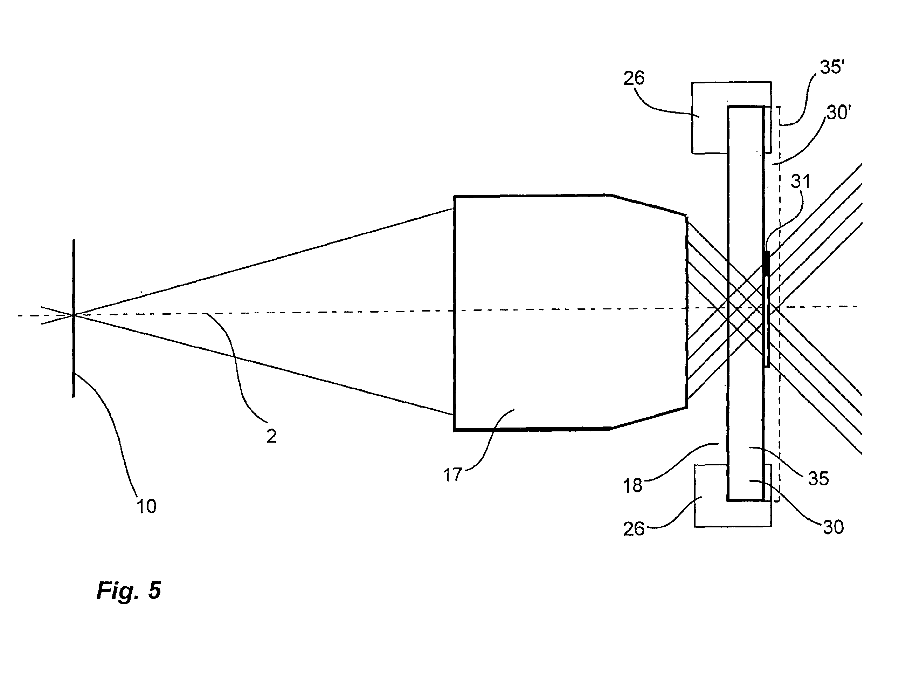

***Fig. 5*** zeigt den schematischen Strahlengang vor und nach dem Kondensor der Durchlicht-Beleuchtung des Koordinaten-Messgeräts, insbesondere für unterschiedlich dicke Masken. Dargestellt ist der Kondensor 17 mit einer optischen Achse 2. Zur Orientierung ist die Zwischenbildebene 10 eingezeichnet.

Der Kondensor 17 ist nahe an eine Maske 30 herangefahren, die auf dem offenen Rahmen eines Messtisches 26 gelagert ist. An der dem Kondensor 17 abgewendeten Oberseite 35 weist die Maske 30 Strukturen 31 auf. Diese Oberseite 35 der Maske 30 wird mit einem bestimmten Bildfeld mit sehr homogener Lichtintensität beleuchtet. Das homogen ausgeleuchtete Bildfeld weist beispielsweise einen Mindestdurchmesser von 0.35 mm bei einer numerischen Apertur von 0.60 auf.

Gestrichelt ist außerdem eine dickere Maske 30' mit einer Oberseite 35' eingezeichnet. Ihre Oberseite 35' ist deutlich weiter von dem Kondensor entfernt. Da die Beleuchtungseinrichtung sehr große homogene Bildfelder erzielt, reicht auch bei der dickeren Maske 30' für die Position der Oberseite 35', welche die Lage der Strukturebenen bestimmt, das Bildfeld für eine Messung noch aus. Dadurch ist ein Nachfokussieren aufgrund Veränderungen der Lage der Strukturebenen, die als Folge der fertigungsbedingten Dickentoleranzen der Masken auftreten, nicht notwendig.

Die vorliegende Erfindung ist in Bezug auf Ausführungsbeispiele beschrieben worden. Es jedoch für jeden auf diesem Fachgebiet tätigen Fachmann offensichtlich, dass Änderungen und Abwandlungen vorgenommen werden können, ohne dabei den Schutzbereich der nachstehenden Ansprüche zu verlassen. Insbesondere kann die Beleuchtungseinrichtung für jede Art von Mess- oder Inspektionssystemen, Mikroskopen, Steppern usw. verwendet werden.

### Bezugszeichenliste

- 1.: Lichtquelle
- 2.: optische Achse
- 3.: Einkoppeloptik
- 4.: optisches Faserbündel
- 5.: Auskoppeloptik
- 6.: Homogenisierungsoptik
- 7.: Mikrowabenkondensor
- 8.: Linsenglied
- 9.: Austrittsöffnung des Faserbündels 4
- 10.: Zwischenbildebene
- 11.: erste Quarzplatte
- 12.: zweite Quarzplatte
- 13.: vordere Außenfläche des Mikrowabenkondensors 6
- 14.: Kittfläche
- 15.: hintere Außenfläche des Mikrowabenkondensors 6
- 16.: Mikrolinsen
- 17.: Kondensor
- 18.: Durchlicht-Objekt
- 19.: Linsengruppe
- 20.: Objektiv
- 21.: Strahlteiler
- 22.: Auflicht-Objekt
- 23.: Granitblock
- 24.: Schwingungsdämpfer
- 25.: Schwingungsdämpfer
- 26.: Messtisch
- 27.: Luftlager
- 28.: Luftlager
- 29.: Laser-Interferometer
- 30.: Maske
- 31.: Struktur
- 32.: Teilerspiegel
- 33.: Auflicht-Lichtquelle
- 34.: Detektoreinrichtung
- 35.: Oberseite der Maske

## Patentansprüche

1. Koordinaten-Messgerät mit
- einem horizontal xy-verschiebbaren Messtisch (26) zur Aufnahme eines Substrates mit einer zu vermessenden Struktur (31),
- einem Beleuchtungssystem mit einer Lichtquelle (1), einem Lichtwellenleiter (4), einer Einkoppeloptik (3) vor dem Lichtwellenleiter (4), einer Auskoppeloptik (5) nach dem Lichtwellenleiter (4), und einer Beleuchtungsoptik (17; 20) zur Ausleuchtung eines Bildfelds,
- und einer Detektoreinrichtung (14), mit der die Position der Struktur als Koordinaten auf dem Substrat bestimmt wird,
**dadurch gekennzeichnet,**
a) **dass** als Lichtwellenleiter ein optisches Faserbündel (4) angeordnet ist,
b) und **dass** zwischen der Auskoppeloptik (5) und der Beleuchtungsoptik (17; 20) eine Homogenisierungsoptik (6) angeordnet ist, welche die ungleichmässige Intensitätsverteilung des aus dem optischen Faserbündel (4) austretenden Lichts im Bildfeld homogenisiert,
c) wobei die Homogenisierungsoptik einen Mikrowabenkondensor (6) und ein Linsenglied (8) umfasst, welche die Austrittsöffnung des Faserbündels (4) in einer Zwischenbildebene (10) zu einem homogenen Zwischenbild überlagern, wobei der Mikrowabenkondensor aus zwei miteinander verkitteten Quarzplatten besteht, die jeweils an den Außenflächen ein dichtes Array von plankonvexen Mikrolinsen aufweisen, wobei die beiden Außenflächen wechselseitig in der Fokusebene der Mikrolinsen an der jeweils gegenüberliegenden Außenfläche stehen.

2. Koordinaten-Messgerät nach Anspruch 1,
**dadurch gekennzeichnet,**
**dass** eine Linsengruppe (19) und ein Objektiv (20) das homogenisierte Zwischenbild aus der Zwischenbildebene (10) verkleinert auf das Substrat abbildet.

3. Koordinaten-Messgerät nach Anspruch 1,
**dadurch gekennzeichnet,**
**dass** das Licht der Lichtquelle (1) über die Einkoppeloptik (5) mit einer großen Numerischer Eintrittsapertur abgenommen und in das optische Faserbündel (4) eingekoppelt wird.

## Claims

1. Coordinate measuring device having
- a horizontally x-y displaceable measuring table (26) for holding a substrate with a structure (32) to be measured,
- an illumination system with a light source (1), an optical waveguide (4), a coupling optics (3) upstream of the optical waveguide (4), a decoupling optics (5) downstream of the optical waveguide (4), and an illumination optics (17; 20) for illuminating an image field,
- and a detector device (14) with the aid of which the position of the structure is determined as coordinates on the substrate,
**characterized**
a) **in that** an optical fibre bundle (4) is arranged as optical waveguide,
b) and **in that** there is arranged between the decoupling optics (5) and the illumination optics (17; 20) homogenizing optics (6) which homogenizes in the image field the uneven intensity distribution of the light exiting from the optical fibre bundle (4),
c) the homogenizing optics comprising a micro honeycomb condenser (6) and a lens element (8) which are superposed on the exit opening of the fibre bundle (4) in an intermediate image plane (10) to form a homogeneous intermediate image, the micro honeycomb condenser consisting of two quartz plates which are cemented to one another and respectively have a dense array of planoconvex micro lenses on the outer surfaces, the two outer surfaces reciprocally being in the focal plane of the micro lenses at the respectively opposite outer surface.

2. Coordinate measuring device according to Claim 1, **characterized in that** a lens group (19) and an objective (20) image the homogenized intermediate image in a demagnified fashion on the substrate from the intermediate image plane (10).

3. Coordinate measuring device according to Claim 1, **characterized in that** the light of the light source (1) is picked up via the coupling optics (5) with a large numerical entrance aperture and is coupled into the optical fibre bundle (4).

## Revendications

1. Appareil de mesure de coordonnées comprenant :
- une table de mesure (26) pouvant coulisser horizontalement dans le sens XY destinée à recevoir un substrat muni d'une structure à mesurer (31) ;
- un système d'éclairage comprenant une source de lumière (1), un guide d'ondes lumineuses (4), une optique d'injection (3) avant le guide d'ondes lumineuses (4), une optique d'extraction (5) après le guide d'ondes lumineuses (4) et une optique d'éclairage (17, 20) pour éclairer un champ d'image ;
- et un dispositif de détection (14) avec lequel la position de la structure est déterminée en tant que coordonnées sur le substrat ;
**caractérisé en ce**
a) **que** le guide d'ondes lumineuses installé est un faisceau de fibres optiques (4) ;
b) et **qu'**entre l'optique d'extraction (5) et l'optique d'éclairage (17, 20) est disposée une optique d'homogénéisation (6) qui homogénéise dans le champ d'image la distribution irrégulière d'intensité de la lumière qui sort du faisceau de fibres optiques (4) ;
c) l'optique d'homogénéisation comprenant un condenseur à microalvéoles (6) et un élément lentille (8) qui se superposent à l'ouverture d'extraction du faisceau de fibres (4) pour donner une image intermédiaire homogène dans un plan d'image intermédiaire (10), le condenseur à microalvéoles étant constitué de deux plaques en quartz collées l'une à l'autre qui présentent respectivement sur leur surface extérieure un réseau dense de microlentilles plan-convexes, les deux surfaces extérieures se trouvant mutuellement dans le plan focal des microlentilles sur la surface extérieure respectivement opposée.

2. Appareil de mesure de coordonnées selon la revendication 1, **caractérisé en ce qu'**un groupe de lentilles (19) et un objectif (20) représentent dans un format réduit sur le substrat l'image intermédiaire homogénéisée provenant du plan d'image intermédiaire (10).

3. Appareil de mesure de coordonnées selon la revendication 1, **caractérisé en ce que** la lumière de la source de lumière (1) est prélevée par le biais de l'optique d'injection (5) avec une grande ouverture d'entrée numérique et injectée dans le faisceau de fibres optiques (4).
